# EUROPEAN PATENT APPLICATION

(11) **EP 4 510 435 A1**
(43) Date of publication of application: **19.02.2025**
(21) Application number: 24193115.3
(22) Date of filing: 06.08.2024
(51) Int. Cl.: H02M 3/158, H02M 1/00, H02M 7/00, G06F 1/26, H01L 23/498

(54) **THREE DIMENSIONAL SWITCHING VOLTAGE REGULATOR**

(30) Priority: 14.08.2023 KR 20230106210
(71) Applicant: SAMSUNG ELECTRONICS CO., LTD., Yeongtong-gu Suwon-si, Gyeonggi-do 16677 (KR)
(72) Inventor: JEON, Byungchul, 16677 Suwon-si (KR); HUH, Junho, 16677 Suwon-si (KR)
(74) Representative: Marks & Clerk LLP

(57) **Abstract**

Provided is a switching voltage regulator including: a converting circuit configured to receive an input voltage and to generate an output voltage through a switching operation; and a control circuit configured to cause the output voltage to be generated by controlling the switching operation, wherein the converting circuit includes: at least one switch formed on a first die and configured to perform the switching operation under control of the control circuit; and at least one blocking transistor formed on a second die and electrically connected to at least one first transistor, and wherein the first die is vertically stacked on the second die.

## Description

### 1. Technical Field

The present invention generally relates to a switching voltage regulator, and to a method of manufacturing the switching voltage regulator. 2. Background

It is common for electronic products to be supplied with a constant voltage as an operating voltage. Therefore, a voltage controller is typically required to supply a constant voltage to the electronic products. A switching voltage regulator may be used as the voltage controller.

A switching voltage regulator outputs a constant voltage through a switching operation of internal switches. Accordingly, conversion efficiency of the switching voltage regulator is associated with switching loss occurring during the switching operation. Such switching loss needs to be reduced to improve the conversion efficiency of the switching voltage regulator.

### SUMMARY

According to an aspect of the present invention, there is provided a switching voltage regulator as defined by claim 1. According to another aspect of the invention, there is provided a method of manufacturing a switching voltage regulator as defined by claim 14. Preferred embodiments are defined by the dependent claims.

According to an aspect of the disclosure, a switching voltage regulator includes: a converting circuit configured to receive an input voltage and to generate an output voltage through a switching operation; and a control circuit configured to cause the output voltage to be generated by controlling the switching operation, wherein the converting circuit includes: at least one switch formed on a first die and configured to perform the switching operation under control of the control circuit; and at least one blocking transistor formed on a second die and electrically connected to at least one first transistor, and wherein the first die is vertically stacked on the second die.

According to an aspect of the disclosure, a switching voltage regulator includes: a first converter connected to an input voltage and including a first plurality of switches operating at a first switching frequency; and a second converter connected to a ground voltage and including a second plurality of switches operating at a second switching frequency, wherein the second switching frequency is higher than the first switching frequency, wherein the first plurality of switches are formed on a first die, and the second plurality of switches are formed on a second die, and wherein the first die and the second die are fabricated through different processes having different figure of merit (FOM) characteristics.

According to an aspect of the disclosure, a switching voltage regulator includes: a substrate; a first die stacked on the substrate, wherein a blocking transistor and a control circuit are formed on the first die; and a second die stacked on the first die, wherein a plurality of transistors are formed on the second die, wherein the blocking transistor is configured to block an input voltage, wherein the plurality of transistors are configured to perform a switching operation under control of the control circuit, and wherein the blocking transistor and the plurality of transistors are configured to operate as a converting circuit of a DC-DC converter.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1A is a block diagram illustrating an example of a switching voltage regulator according to an example embodiment;
FIG. 1B is a diagram illustrating an example of a three-dimensional implementation of a power stage circuit of FIG. 1;
FIG. 2A is a circuit diagram illustrating an example of a converting circuit of FIG. 1 implemented as a buck converter;
FIG. 2B is a circuit diagram illustrating an example of a first switch of FIG. 2A;
FIG. 2C is a circuit diagram illustrating an example of a second switch of FIG. 2A;
FIG. 3A is a circuit diagram illustrating an example in which the converting circuit of FIG. 1 is implemented as a buck converter;
FIG. 3B is a circuit diagram illustrating an example of a first switch of FIG. 3A;
FIG. 3C is a circuit diagram illustrating an example of a second switch of FIG. 3A;
FIG. 4A is a circuit diagram illustrating an example in which the converting circuit of FIG. 1 is implemented as a buck converter;
FIG. 4B is a circuit diagram illustrating an example of a first switch of FIG. 4A;
FIG. 4C is a circuit diagram illustrating an example of a second switch of FIG. 4A;
FIG. 5 is a diagram illustrating an example in which the converting circuit of FIG. 1 is implemented as a buck converter;
FIG. 6 is a diagram illustrating an example in which the converting circuit of FIG. 1 is implemented as a buck converter;
FIG. 7 is a diagram illustrating an example in which the converting circuit of FIG. 1 is implemented as a buck converter;
FIG. 8 is a circuit diagram illustrating an example in which the converting circuit of FIG. 1 is implemented as a boost converter;
FIG. 9 is a circuit diagram illustrating an example in which the converting circuit of FIG. 1 is implemented as a merged converter;
FIG. 10 is a circuit diagram illustrating an example in which the converting circuit of FIG. 1 is implemented as a merged converter;
FIG. 11A is a block diagram illustrating an example of a control circuit of FIG. 1;
FIG. 11B is a diagram illustrating an example in which the control circuit of FIG. 11A is implemented on a single die;
FIG. 12A is a block diagram illustrating an example of the control circuit of FIG. 1;
FIG. 12B is a diagram illustrating an example in which the control circuit of FIG. 12A is implemented in a three-dimensional form; and
FIGS. 13A, 13B, 13C and 13D are diagrams illustrating an example of a three-dimensional implementation of a switching voltage regulator according to an example embodiment.

### DETAILED DESCRIPTION

Hereinafter, example embodiments will be described with reference to the accompanying drawings.

In the following description, like reference numerals refer to like elements throughout the specification. Well-known functions or constructions are not described in detail since they would obscure the one or more example embodiments with unnecessary detail. According to embodiments, a plurality of "unit", "module", "member", and "block" may be implemented as a single component or a single "unit", "module", "member", and "block" may include a plurality of components.

It will be understood that when an element is referred to as being "connected" with or to another element, it can be directly or indirectly connected to the other element.

Also, when a part "includes" or "comprises" an element, unless there is a particular description contrary thereto, the part may further include other elements, not excluding the other elements.

Throughout the description, when a member is "on" another member, this includes not only when the member is in contact with the other member, but also when there is another member between the two members.

Herein, the expression "at least one of a, b or c" indicates "only a," "only b," "only c," "both a and b," "both a and c," "both b and c," or "all of a, b, and c."

It will be understood that, although the terms first, second, third, etc., may be used herein to describe various elements, the invention should not be limited by these terms. These terms are only used to distinguish one element from another element.

As used herein, the singular forms "a," "an" and "the" are intended to include the plural forms as well, unless the context clearly indicates otherwise.

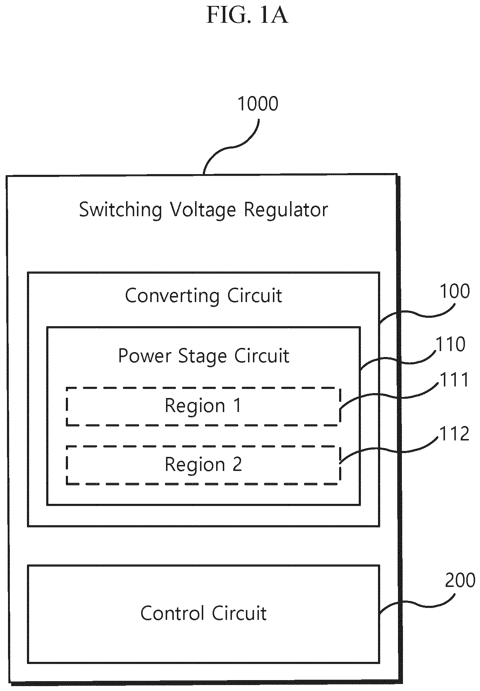

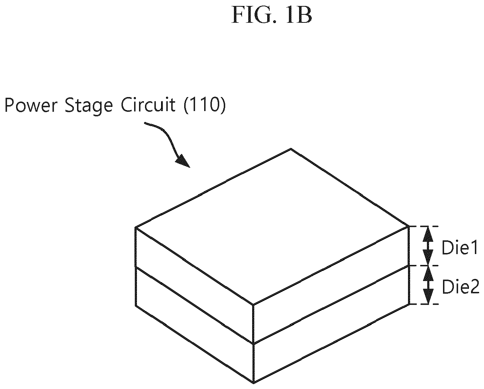

FIG. 1A is a block diagram illustrating an example of a switching voltage regulator 1000 according to an example embodiment, and FIG. 1B is a diagram illustrating an example of a three-dimensional implementation of a power stage circuit 110 of FIG. 1.

The switching voltage regulator 1000 according to an example embodiment is implemented using at least two dies, wherein each of the two dies may be formed by different processes. For example, devices having large switching loss may be formed on dies formed by processes having relatively improved figure of merit (FOM) characteristics, and other devices may be formed on dies formed by processes having relatively low FOM characteristics. Accordingly, switching losses of the switching voltage regulator 1000, according to an example embodiment, may be reduced.

As is described below in more detail with reference to FIGS. 1A and 1B, the switch voltage regulator 1000 includes a converting circuit 100 and a control circuit 200.

The converting circuit 100 receives an input voltage, and generates an output voltage through a switching operation. For example, the converting circuit 100 may be implemented as a DC-DC converter. In an embodiment, the converting circuit 100 may output a constant voltage.

In an example embodiment, the converting circuit 100 may be implemented as a buck converter. As used herein, a buck converter may also be referred to herein as a step-down converter. In an embodiment, the converting circuit 100 may generate an output voltage that is lower than an input voltage through a switching operation in which alternate switching on and off is repeated at regular intervals.

In an example embodiment, the converting circuit 100 may be implemented as a boost converter. As used here, a boost converter may also be referred to as a step-up converter. In an embodiment, the converting circuit 100 may generate an output voltage that is higher than the input voltage through a switching operation in which switching on and off are repeated at regular intervals.

In an example embodiment, the converting circuit 100 may be implemented as a buck-boost converter supporting the functions of both a buck converter and a boost converter. Hereinafter, the converting circuit 100 implemented as a buck converter will mainly be described for brevity of description.

The converting circuit 100 may include the power stage circuit 110. The power stage circuit 110 may receive an input voltage, and may include at least one transistor performing a switching operation. According to an example embodiment, the converting circuit 100 may further include a filter circuit that includes a combination of an inductor and a capacitor. The filter circuit may filter a voltage, transmitted from the power stage circuit 110, to output a direct current (DC) voltage.

In an example embodiment, the power stage circuit 110 may be implemented using devices formed on different dies. For example, devices constituting the power stage circuit 110 may be formed on different dies. In an embodiment, dies corresponding to the power stage circuit 110 may be formed by different processes. Accordingly, FOM characteristics of the dies corresponding to the power stage circuit 110 may be different from each other. The FOM characteristics may include on-resistance (Ron) characteristics and/or gate charge (Qg) characteristics.;

For example, according to an example embodiment, among the devices constituting the power stage circuit 110, devices performing a switching operation at high speed may be formed on a die having relatively improved FOM characteristics, and remaining devices may be formed on a die having relatively low FOM characteristics. Accordingly, switching losses of the power stage circuit 110 may be effectively reduced.

This will now be described in more detail. The power stage circuit 110 may include devices, belonging to a first region 111, and devices belonging to a second region 112. For example, the devices belonging to the first region 111 may include a transistor performing a switching operation at high speed, and the devices belonging to the second region 112 may include a transistor blocking an input voltage and/or a transistor performing a switching operation at low speed.

In an embodiment, a first die Die1 is formed by a process having relatively improved FOM characteristics, and a second die Die2 is formed by a process having relatively low FOM characteristics. In such an embodiment, the devices belonging to the first region 111 may be implemented on the first die Die1, and the devices belonging to the second region 112 may be implemented on the second die Die2. Accordingly, a transistor performing a switching operation at high speed may be implemented on the first die Die1 having relatively improved FOM characteristics, and a transistor performing a blocking operation may be implemented on the second die Die2 having relatively low FOM characteristics.

In general, conversion efficiency of a switching voltage regulator is affected by losses caused by parasitic resistance in a power transfer path and switching losses occurring during a switch operation. To reduce the losses caused by the parasitic resistance in the power transfer path, a switching voltage regulator may be placed as close to a load as possible. In such a configuration, values of an inductor and a capacitor of the related filter circuit may be reduced by placing the switching voltage regulator as close to the load as possible. In addition, an increase in a switching frequency will in turn reduce the values of the inductor and capacitor. However, the increased switching frequency also causes an increase in switching loss. As a result, there is a need to reduce the switching loss caused by a high-speed switching operation to increase the conversion efficiency of the switching voltage regulator.

According to an example embodiment, the power stage circuit 110 may implement a transistor, performing a high-speed switching operation, on the first die Die1 having improved FOM characteristics. Accordingly, the switching loss of the power stage circuit 110 may be significantly reduced.

When a device unrelated to switching loss or unaffected by switching loss, such as a transistor performing a blocking operation or a transistor performing a switching operation at a low speed, is implemented on the first die Die1 having improved FOM characteristics, the number of stages that should be stacked to receive voltage may be increased. However, due to the increased number of the stages of the stack, delay may be increased. In addition, complexity of a circuit may be increased to appropriately control a voltage of each stage, and a balance capacitor, or the like, may be required.

According to an example embodiment, the power stage circuit 110 may implement devices other than transistors performing a switching operation at high speed on the second die Die2 having relatively low FOM characteristics. Accordingly, issues such as increased complexity of a circuit, and delay caused by an increase in the number of stages of the stack, may be addressed.

According to an example embodiment, as illustrated in FIG. 1B, the power stage circuit 110 may be implemented in a three-dimensional form by vertically stacking the first die Die1 and the second die Die2 fabricated by different processes. Accordingly, the power transfer path between the first die Die1 and the second die Die2 may be significantly reduced, so that parasitic resistance components may be reduced. In addition, an area occupied by the power stage circuit 110 on a plane may also be reduced as a result of the stacked configuration.

Continuing to refer to FIG. 1A, the control circuit 200 may control the overall operation of the converting circuit 100. For example, the control circuit 200 may generate a gate voltage to be provided to gates of transistors included in the converting circuit 100, and may provide the generated gate voltage to the converting circuit 100. In addition, the control circuit 200 may control on/off cycles (i.e., open/close cycles) of switching operations of the transistors included in the converting circuit 100.

As described above, the switching voltage regulator 1000 according to an example embodiment may include a device having large switching losses. The device having large switching losses may be formed on a die having relatively improved FOM characteristics, and the remaining devices may be formed on a die having relatively low FOM characteristics. Accordingly, switching losses of the switching voltage regulator 1000 according to an example embodiment may be reduced.

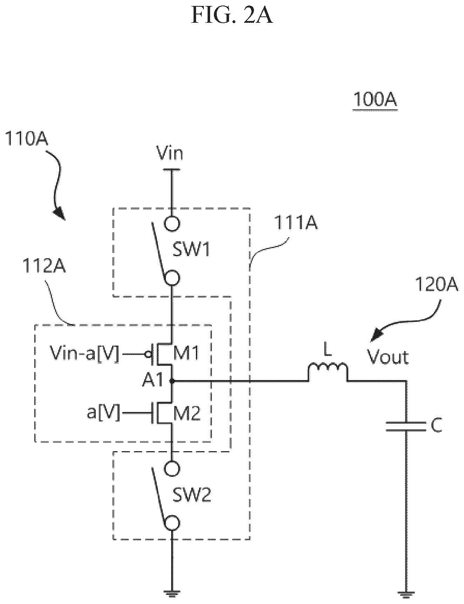

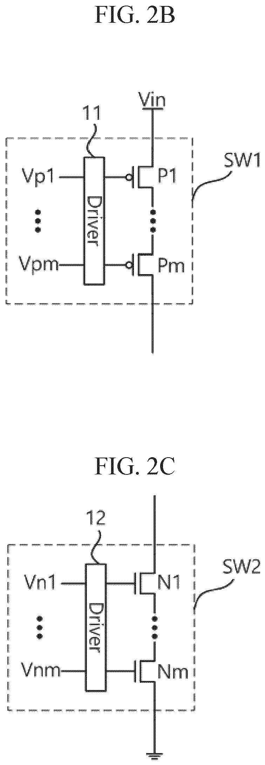

FIGS. 2A, 2B and 2C are diagrams illustrating an example of the converting circuit of FIG. 1 implemented as a buck converter. FIG. 2A is a circuit diagram illustrating an example of the converting circuit of FIG. 1 implemented as a buck converter, FIG. 2B is a circuit diagram illustrating an example of a first switch of FIG. 2A, and FIG. 2C is a circuit diagram illustrating an example of a second switch of FIG. 2A.

Referring to FIG. 2A, a converting circuit 100A may include a power stage circuit 110A and a filter circuit 120A.

The power stage circuit 110A may include a first switch SW1, a second switch SW2, a first transistor M1, and a second transistor M2, all of which are connected in series. For example, the power stage circuit 110A may be implemented by stacking the first switch SW1, the second switch SW2, the first transistor M1, and the second transistor M2.

The first switch SW1 may have one end receiving an input voltage Vin, and may perform a high-speed switching operation in response to control of the control circuit 200 (see FIG. 1A). The second switch SW2 may have one end connected to a ground voltage, and may perform a high-speed switching operation in response to control of the control circuit 200. The first switch SW1 may be referred to as a high-side switch, and the second switch SW2 may be referred to as a low-side switch.

The first transistor M1 and the second transistor M2 may be disposed between the first switch SW1 and the second switch SW2. According to an example embodiment, the first transistor M1 may be implemented as a PMOS (p-channel metal-oxide semiconductor) transistor, and the second transistor M2 may be implemented as an NMOS (n-channel metal-oxide semiconductor) transistor. A voltage of "Vin-a" may be applied to a gate of the first transistor M1, and a voltage of "a" may be applied to a gate of the second transistor M2. The first transistor M1 and the second transistor M2 may serve to block an input voltage Vin and to adjust voltages corresponding to the first and second switches SW1 and SW2. Each of the first transistor M1 and the second transistor M2 may be referred to as a blocking transistor.

The filter circuit 120A may include an inductor L and a capacitor C, and may operate as an LC filter.

In an example embodiment, the first switch SW1 and the second switch SW2 of the power stage circuit 110A may be disposed in a first region 1 1 1A, and devices disposed in the first region 111A may be implemented on a first die Die1 (see FIG. 1B) through a process having relatively improved FOM characteristics.

For example, as illustrated in FIG. 2B, the first switch SW1 may include a plurality of PMOS transistors P1 to Pm and a driver 11 and may be implemented to perform a switching operation in response to gate voltages Vp1 to Vpm received from the control circuit 200. In an embodiment, a process having relatively improved FOM characteristics is used, so that the transistors P1 to Pm included in the first switch SW1 may have a relatively small size compared to the first and second transistors M1 and M2.

Similarly, as illustrated in FIG. 2C, the second switch SW2 may include a plurality of NMOS transistors N1 to Nm and a driver 12, and may be implemented to perform a switching operation in response to gate voltages Vn1 to Vnm received from the control circuit 200. In an embodiment, a process having relatively improved FOM characteristics is used, so that the transistors N1 to Nm included in the second switch SW2 have a relatively small size compared to the first and second transistors M1 and M2.

As described above, the switches SW 1 and SW2 included in the power stage circuit 110A may be implemented through a process having relatively improved FOM characteristics to the switching loss of the power stage circuit 110A.

In an example embodiment, the first transistor M1 and the second transistor M2 of the power stage circuit 110A may be disposed in a second region 112A. Devices implemented on a second die Die2 (see FIG. 1B) through a process having relatively low FOM characteristics.

Accordingly, the first transistor M1 and the second transistor M2 may be implemented with a relatively simple structure. Accordingly, the overall complexity of the power stage circuit 110A may be reduced.

As a result, the power stage circuit 110A according to an example embodiment may have reduced switching loss without increasing the complexity of the circuit.

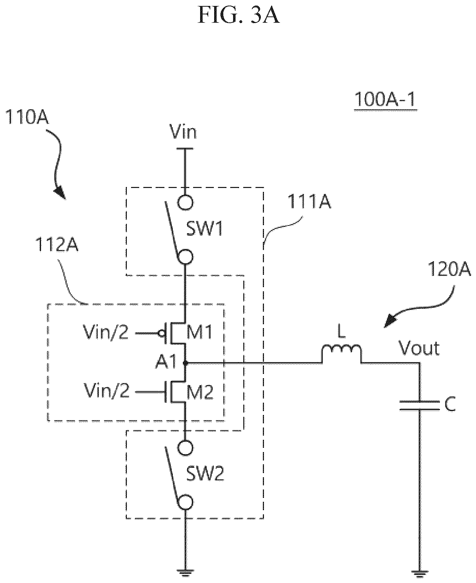

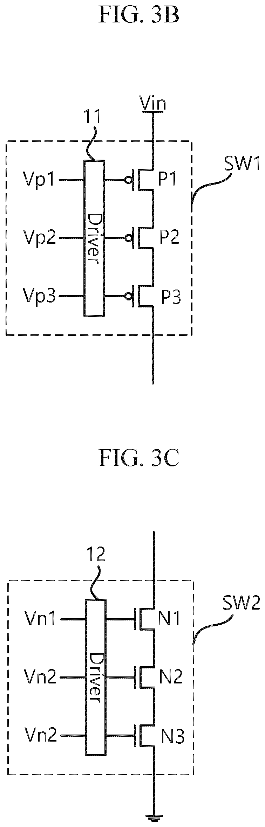

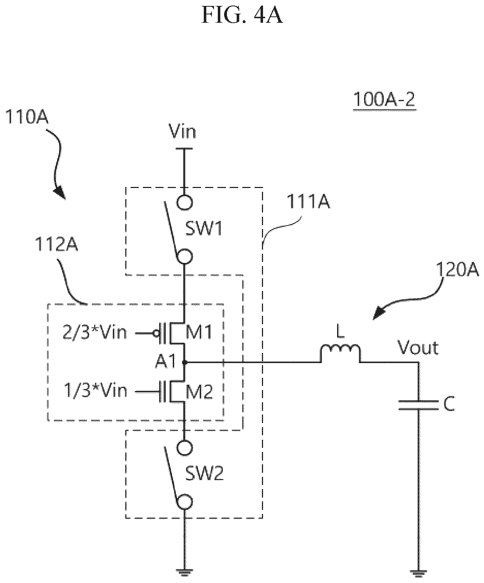

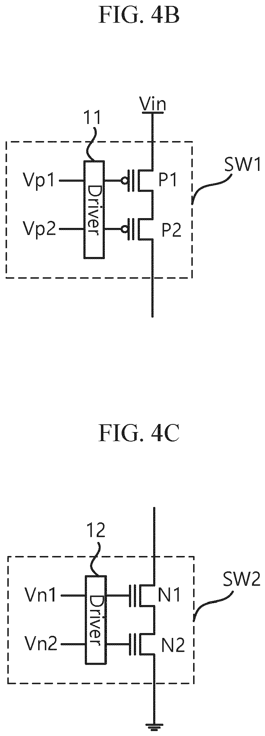

FIGS. 3A, 3B, 3C, 4A, 4B and 4C are diagrams illustrating examples in which the converting circuit of FIG. 1 is implemented as a buck converter. FIGS. 3A to 3C illustrate an example of how to implement switches when relatively high voltages correspond to switches performing high-speed switching operations. FIGS. 4A to 4C illustrate an alternative example of switches where relatively high voltages correspond to switches performing high-speed switching operations.

For ease of description, an example is provided in which the converting circuits of FIGS. 3A and 4A are implemented as the same buck converter as described in FIG. 2. In FIG. 3A, an example is provided in which a voltage of "Vin/2" is provided to first and second transistors M1 and M2. In FIG. 4A, an example is provided in which a voltage of "2/3*Vin" and a voltage of "1/3*Vin" are provided to first and second transistors M1 and M2, respectively.

Referring to FIG. 3A, a converting circuit 100A-1 may be implemented to provide a voltage of "Vin/2" to each of the first and second transistors M1 and M2. In this embodiment, the first and second transistors M1 and M2 may block the voltage of "Vin/2." Accordingly, each of the first and second switches SW1 and SW2 may correspond to the voltage of "Vin/2." For example, each of the first and second switches SW1 and SW2 should be capable of withstanding a relatively high voltage level of "Vin/2" during a switching operation.

In an embodiment, the first switch SW1 may be implemented to stack a relatively large number of transistors, as illustrated in FIG. 3B. For example, the first switch SW1 may be implemented to connect three transistors P1 to P3 in series.

Similarly, the second switch SW2 may be implemented to stack a relatively large number of transistors, as illustrated in FIG. 3C. For example, the second switch SW2 may be implemented to connect three transistors N1 to N3 in series.

Referring to FIG. 4A, a converting circuit 100A-2 may be implemented to provide a voltage of "`2/3 *Vin"' and a voltage of '"1/3 *Vin"` to first and second transistors M1 and M2, respectively. In this embodiment, the first and second transistors M1 and M2 may block the voltage of "2/3 *Vin." Accordingly, first and second switches SW1 and SW2 may each correspond to the voltage of "Vin/3." For example, each of the first and second switches SW1 and SW2 should be capable of withstanding a relatively low voltage level of "Vin/3" during a switching operation.

In an embodiment, the first switch SW1 may be implemented to stack a relatively small number of transistors, as illustrated in FIG. 4B. For example, the first switch SW1 may be implemented to connect two transistors P1 and P2 in series.

Similarly, the second switch SW2 may be implemented to stack a relatively small number of transistors, as illustrated in FIG. 4C. For example, the second switch SW2 may be implemented to connect two transistors N1 and N2 in series.

As discussed above, the number of stages of stacked transistors included in the converting circuit 100A may vary, and these stacked transistors may be implemented using a process having improved FOM characteristics, based on a level of a voltage blocked by a blocking transistor. For example, the higher the level of a voltage blocked by a blocking transistor, the smaller the number of stages of stacked transistors constituting a switch may be designed.

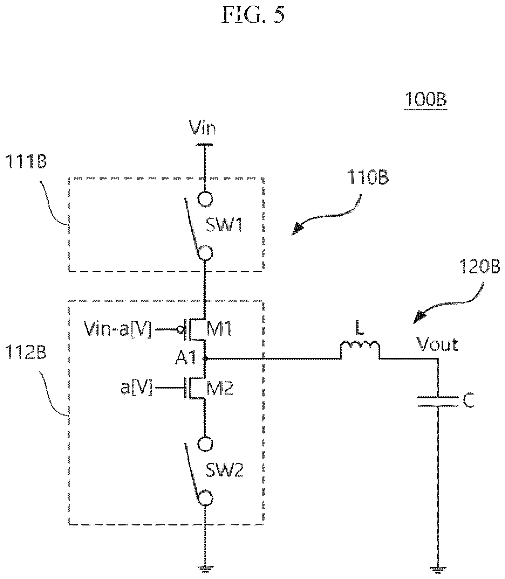

FIG. 5 is a diagram illustrating an example in which the converting circuit of FIG. 1 is implemented as a buck converter. The converting circuit 100B of FIG. 5 is similar to the converting circuit 100A of FIG. 2A. Therefore, redundant descriptions will be omitted below for brevity of description.

Referring to FIG. 5, the converting circuit 100B may include a power stage circuit 110B and a filter circuit 120B.

In an example embodiment, a first switch SW1 of the power stage circuit 110B may be disposed in a first region 111B. The first switch SW1 disposed in the first region 111B may be implemented on a first die Die1 through a process having relatively improved characteristics. A second switch SW2 and the first and second transistors M1 and M2 of the power stage circuit 110B may be disposed in a second region 112B, and devices disposed in the second region 112B may be implemented on a second die Die2 through a process having relatively low FOM characteristics.

In the case of a buck converter, switching loss occurring in the first switch SW1, a high-side switch, is greater than switching loss occurring in the second switch SW2, a low-side switch. Therefore, the second switch SW2 may be formed together with the first and second transistors M1 and M2 through a process having relatively low FOM characteristics, as illustrated in FIG. 5.

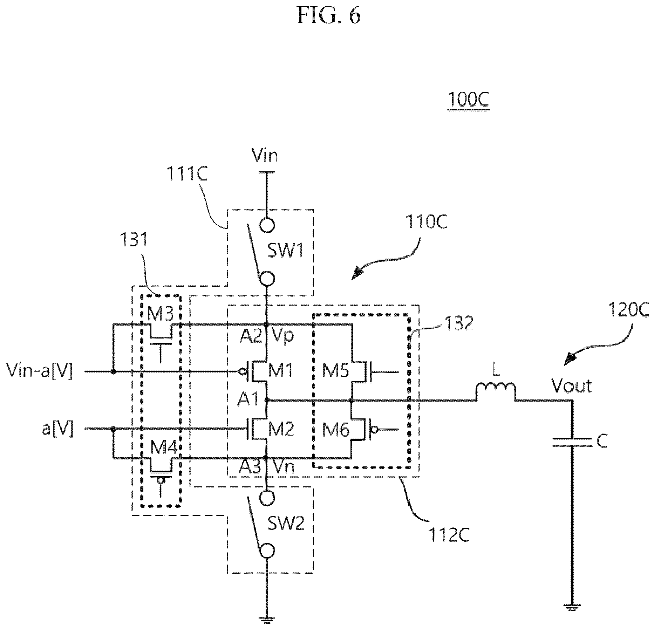

FIG. 6 is a diagram illustrating an example in which the converting circuit of FIG. 1 is implemented as a buck converter. A converting circuit 100C of FIG. 6 is similar to the converting circuit 100A of FIG. 2A. Therefore, redundant descriptions will be omitted below for brevity of description.

Referring to FIG. 6, the converting circuit 100C may include a power stage circuit 110C and a filter circuit 120C. The power stage circuit 110C may include first and second auxiliary circuits 131 and 132.

The first auxiliary circuit 131 may include a third transistor M3 and a fourth transistor M4. The third transistor M3 may have one end, connected to a gate of the first transistor M1, and the other end connected to a first switch SW1. The fourth transistor M4 may have one end, connected to a gate of the second transistor M2, and the other end connected to a second switch SW2.

The second auxiliary circuit 132 may include a fifth transistor M5 and a sixth transistor M6. The fifth transistor M5 may have one end, connected to a first node A1, and the other end connected to the first switch SW1. The sixth transistor M6 may have one end, connected to the first node A1, and the other end connected to the second switch SW2.

The first and second auxiliary circuits 131 and 132 may control a voltage level Vp at a second node A2 and a voltage level Vn at a third node A3 such that the levels Vp and Vn do not exceed a predetermined voltage. For example, the first and second auxiliary circuits 131 and 132 control the voltage level Vp at the second node A2 such that the voltage level Vp does not exceed a voltage of "Vin-a," and may control the voltage level Vn at the third node A3 such that the voltage level Vn does not exceed a voltage of "a."

In an example embodiment, the first auxiliary circuit 131 may be disposed in a first region 111C, and devices disposed in the first region 111C may be implemented on a first die Die1 through a process having relatively improved FOM characteristics. The second auxiliary circuit 132 may be disposed in a second region 112C, and devices disposed in the second region 112C may be implemented on a second die Die2 through a process with relatively low FOM characteristics.

However, the foregoing is only an example, and both the first and second auxiliary circuits 131 and 132 may be disposed in the first region 111C. Alternatively, both the first and second auxiliary circuits 131 and 132 may be disposed in the second region 112C. In an example embodiment, the converting circuit 100C may include only one of the first and second auxiliary circuits 131 and 132.

Through these auxiliary circuits 131 and 132, the converting circuit 100C, according to an example embodiment, may control "Vp/Vn" to change only within a safe operation area (SOA). Accordingly, reliability of transistors included in the first region 111C formed through a process having relatively improved FOM characteristics may be improved.

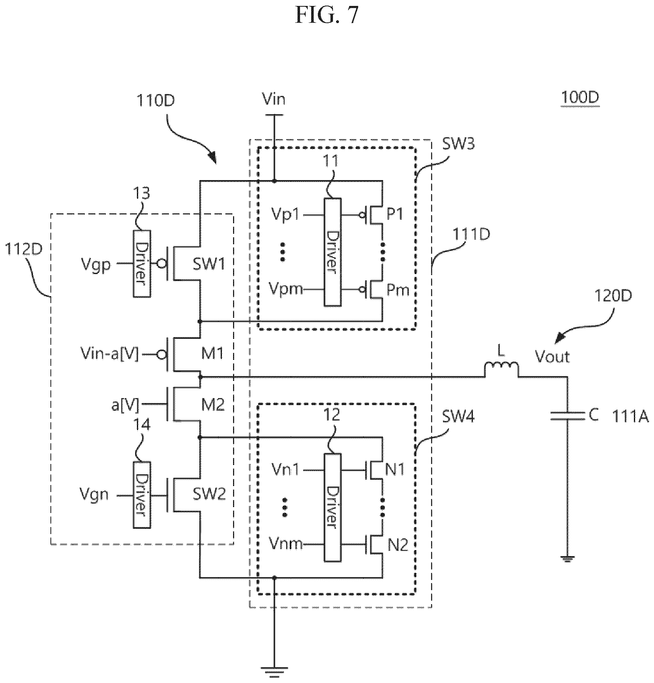

FIG. 7 is a diagram illustrating an example in which the converting circuit of FIG. 1 is implemented as a buck converter. The converting circuit 100D of FIG. 7 is similar to the converting circuit 100A of FIG. 2A. Therefore, redundant descriptions will be omitted below for brevity of description.

Referring to FIG. 7, the converting circuit 100D may include a power stage circuit 110D and a filter circuit 120D. The power stage circuit 110D may include first to fourth switches SW1 to SW4.

Unlike the converting circuit 100A of FIG. 2A, the converting circuit 100D of FIG. 7 may include two switches SW1 and SW3, connected in parallel, as high-side switches. The first switch SW1 may be disposed in a second region 112D. Thus, the first switch SW1 may be implemented on a first die Die1 through a process having relatively improved FOM characteristics. The third switch SW3 may be disposed in a first region 111D. Thus, the third switch SW3 may be implemented on a second die Die2 through a process having relatively low FOM characteristics. The third switch SW3 may be implemented as, for example, one or more PMOS transistors.

In addition, the converting circuit 100D may include two switches SW2 and SW4 connected in parallel as low-side switches. The second switch SW2 may be disposed in the second region 112D. Thus, the second switch SW2 may be implemented on the first die Die1 through a process having relatively improved FOM characteristics. The fourth switch SW4 may be disposed in the first region 111D. Thus, the fourth switch SW4 may be implemented on the second die Die2 through a process having relatively low FOM characteristics. The fourth switch SW4 may be implemented with, for example, one or more NMOS transistors.

As described above, the converting circuit 100D according to an example embodiment may include a plurality of switches, respectively connected in parallel to a high side and a low side. Switches included in the high side may be formed through different processes, and switches included in the low side may also be formed through different processes.

However, the foregoing is only an example, and the converting circuit 100D according to an example embodiment may include a plurality of switches connected in parallel to only one of the high side and the low side.

In FIGS. 2 to 7, the converting circuit has been described as being implemented as a buck converter. However, this is only an example, and the converting circuit according to an example embodiment may be implemented as various circuits. Hereinafter, other embodiments of the converting circuit will be described in more detail.

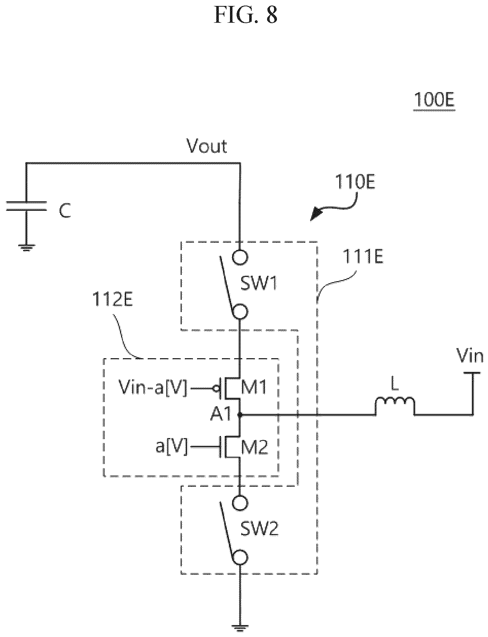

FIG. 8 is a circuit diagram illustrating an example in which the converting circuit of FIG. 1 is implemented as a boost converter.

Referring to FIG. 8, a converting circuit 100E may include a power stage circuit 110E, an inductor L, and a capacitor C. The inductor L may be connected between an input voltage Vin and a first node A1 of the power stage circuit 110E. The capacitor C may be connected between a ground voltage and the power stage circuit 110E.

In an example embodiment, the power stage circuit 110E may include first and second switches SW1 and SW2 and first and second transistors M1 and M2. The first and second switches SW1 and SW2 may be disposed in a first region 111E and may be implemented on a first die Die1 through a process having relatively improved FOM characteristics. The first and second transistors M1 and M2 may be disposed in a second region 112E and may be implemented on a second die Die2 through a process having relatively low FOM characteristics.

As described above, the converting circuit 100E according to an example embodiment may be implemented as a boost converter, and switching loss may be significantly reduced.

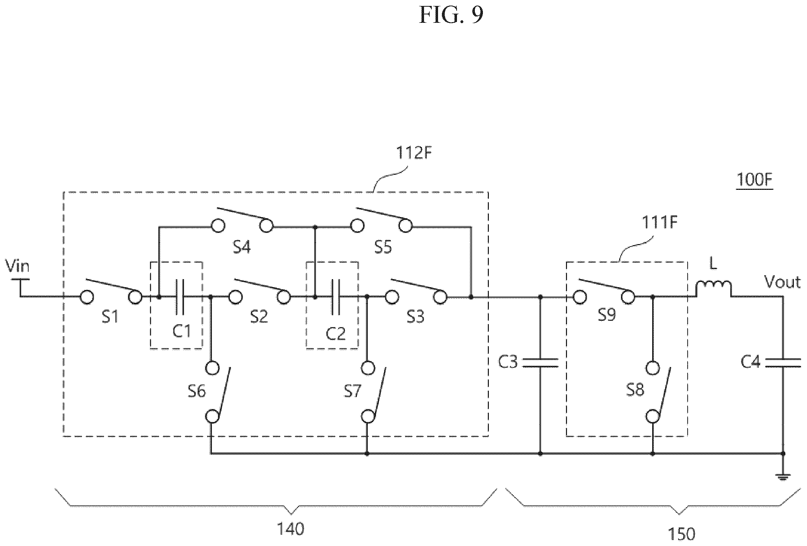

FIG. 9 is a circuit diagram illustrating an example in which the converting circuit of FIG. 1 is implemented as a merged converter. In FIG. 9, a two-stage merged converter is illustrated as an example.

Referring to FIG. 9, a converting circuit 100F may include a first converter 140 and a second converter 150.

The first converter 140 may include a combination of a plurality of switches and a capacitor. For example, the first converter 140 may include first to seventh switches S1 to S7 and first and second capacitors C1 and C2, as illustrated in FIG. 9. The first to seventh switches S1 to S7 may perform a switching operation in response to control of the control circuit 200 (see FIG. 1A) to be periodically turned on and off (i.e., opened and closed).

The second converter 150 may include a combination of a plurality of switches, a capacitor, and an inductor. For example, the second converter 150 may include eighth and ninth switches S8 and S9, third and fourth capacitors C3 and C4, and an inductor L. The eighth and ninth switches S8 and S9 may perform a switching operation in response to the control of the control circuit 200 to be periodically turned on and off (i.e., opened and closed).

The first converter 140 may receive an input voltage Vin, and may decrease the input voltage Vin through a switching operation. The first converter 140 may operate at a relatively low switching frequency, as compared to the second converter 150.

The second converter 150 may receive the decreased input voltage from the first converter 140, and may output the decreased input voltage as a direct current (DC) voltage. The second converter 150 may operate at a relatively high switching frequency, as compared to the first converter 140.

In an example embodiment, the switches S1 to S7 of the first converter 140, which should be capable of withstanding a high voltage while operating at a relatively low switching frequency, may be disposed in a second region 112F. Accordingly, the switches S1 to S7 of the first converter 140 may be implemented on a second die Die2 through a process having relatively low FOM characteristics.

In an example embodiment, the switches S8 and S9 of the second converter 150, which should be capable of withstanding a low voltage while operating at a relatively high switching frequency, may be disposed in a first region 111F. Accordingly, the switches S8 and S9 of the second converter 150 may be implemented on a first die Die1 through a process having relatively improved FOM characteristics.

As described above, the converting circuit 100F according to an example embodiment may be implemented through two converters having different switching frequencies. In an embodiment, the converters may be formed through different processes, respectively. Accordingly, switching losses of the converting circuit 100F may be reduced.

It will be understood that the two-stage merged converter of FIG. 9 is an example and may be modified in various ways according to example embodiments.

In an example embodiment, the third capacitor C3 may be omitted. For example, the second converter 150 may be configured to include eighth and ninth switches S8 and S9, a fourth capacitor C4, and an inductor L.

Alternatively, in an example embodiment, the third capacitor C3 may be implemented to have relatively low capacitance. For example, the second converter 150 may include eighth and ninth switches S8 and S9, third and fourth capacitors C3 and C4, and an inductor L, and the third capacitor C3 may be implemented to have capacitance, higher than capacitance of the fourth capacitor C4.

Even when the third capacitor C3 is omitted or implemented to have low capacitance, the first converter 140 and the second converter 150 may be formed through different processes. Thus, switching losses of the converting circuit 100F may be reduced.

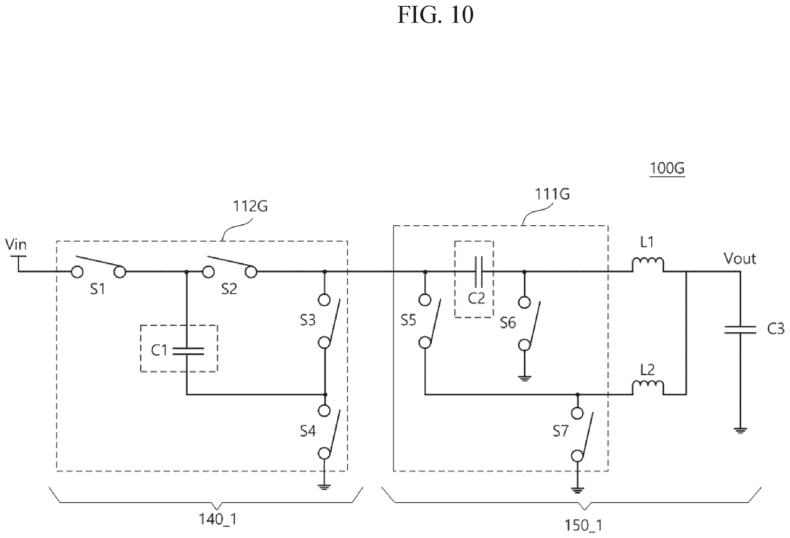

FIG. 10 is a circuit diagram illustrating an example in which the converting circuit of FIG. 1 is implemented as a merged converter. Similar to FIG. 9, the converting circuit 100G of FIG. 10 may be implemented as a two-stage merged converter. The converting circuit 100G of FIG. 10 is similar to the converting circuit 100F of FIG. 9. Therefore, redundant descriptions will be omitted below for brevity of description.

Referring to FIG. 10, the converting circuit 100G may include a first converter 140_1 and a second converter 150_1.

The first converter 140_1 may include a combination of a plurality of switches and a single capacitor. For example, the first converter 140_1 may include first to fourth switches S1 to S4 and a first capacitor C1, as illustrated in FIG. 10. The first to fourth switches S1 to S4 may operate at a relatively low switching frequency.

The second converter 150_1 may include a combination of a plurality of switches, a plurality of capacitors, and a plurality of inductors. For example, the second converter 150_1 may include fifth to seventh switches S5 to S7, second and third capacitors C2 and C3, and first and second inductors L1 and L2. The fifth to seventh switches S5 to S7 may operate at a relatively high switching frequency.

In an example embodiment, the switches S1 to S4 of the first converter 140_1, which should be capable of withstanding a high voltage while operating at a relatively low switching frequency, may be disposed in a second region 112G. The switches S5 to S7 of the second converter 150_1, which should be capable of withstanding a low voltage while operating at a relatively high switching frequency, may be disposed in a first region 111G. Accordingly, the switches S1 to S4 of the first converter 140_1 and the switches S5 to S7 of the second converter 150_1 may be formed through different processes. Accordingly, switching loss of the converting circuit 100G may be reduced.

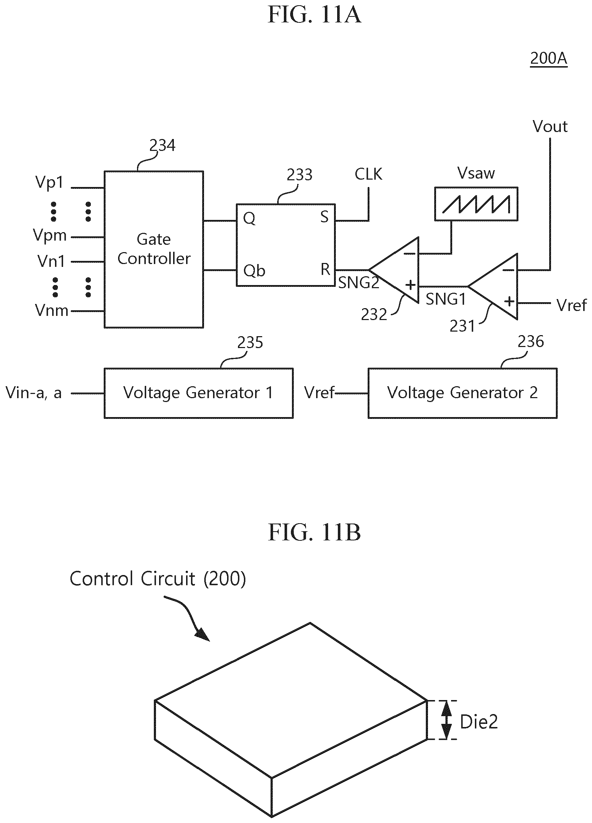

FIG. 11A is a block diagram illustrating an example of the control circuit of FIG. 1. FIG. 11B is a diagram illustrating an example in which the control circuit of FIG. 11A is implemented on a single die.

Referring to FIG. 11A, a control circuit 200A may include an amplifier 231, a comparator 232, a flip-flop 233, a gate controller 234, a first voltage generator 235, and a second voltage generator 236.

The amplifier 231 may receive an output voltage Vout from a converting circuit 100. The amplifier 231 may compare the output voltage Vout and a reference voltage Vref to output a result of the comparison as a first signal SNG1.

The comparator 232 may receive a sawtooth waveform signal Vsaw. The comparator 232 may receive the first signal SNG1 from the amplifier 231. The comparator 232 may compare the sawtooth waveform signal Vsaw and the first signal SNG1 to output a result of the comparison as a second signal SNG2. While a sawtooth waveform, is used in this example, the invention is not limited thereto.

The flip-flop 233 may receive a clock signal CLK and the second signal SNG2. The flip-flop 233 may output an output signal Q and an inverted output signal Qb based on the clock signal CLK and the second signal SNG2.

The gate controller 234 may receive the output signal Q and the inverted output signal Qb from the flip-flop 233. The gate controller 234 may generate voltages to be provided to gates of switches P1 to Pm and N1 to Nm (see FIG. 2A) of the converting circuit 100A (see FIG. 2A) based on the output signal Q and the inverted output signal Qb.

The first voltage generator 235 may generate voltages provided to gates of the transistors M1 and M2 (see FIG. 2A) of the converting circuit 100A.

The second voltage generator 236 may generate a reference voltage Vref provided to the amplifier 231.

In an example embodiment, the control circuit 200A may be implemented through a single process. For example, the control circuit 200A may be implemented on a second die Die2 through a process having relatively low FOM characteristics, as illustrated in FIG. 11B. In an embodiment, the control circuit 200A may be implemented on the second die Die2 together with devices of the converting circuit 100 disposed in the second region 112 (see FIG. 1A).

However, the foregoing is only an example, and example embodiments are not limited thereto. For example, the control circuit 200A may be implemented on an independent die on which devices of the converting circuit 100 are not implemented. In an embodiment, the control circuit 200A may be implemented to be vertically stacked on the dies Die1 and Die2, on which the converting circuit 100 is implemented, such that loss caused by parasitic resistance is significantly reduced.

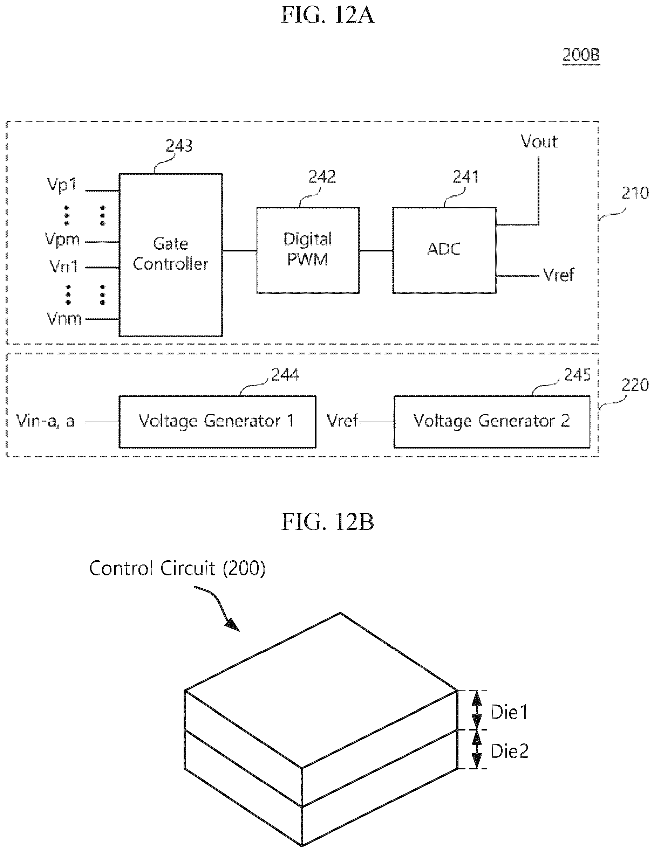

FIG. 12A is a block diagram illustrating an example of the control circuit of FIG. 1. FIG. 12B is a diagram illustrating an example in which the control circuit of FIG. 12A is implemented in a three-dimensional form. A control circuit 200B of FIG. 12A is similar to the control circuit 200A of FIG. 11A. Therefore, redundant descriptions will be omitted below for brevity of description.

Referring to FIG. 12A, the control circuit 200B may include an analog-to-digital converter 241, a digital pulse width modulator (hereinafter referred to as a "digital PWM") 242, a gate controller 243, a first voltage generator 244, and a second voltage generator 245.

The analog-to-digital converter 241 may receive the output voltage Vout from the converting circuit 100. The analog-to-digital converter 241 may compare the output voltage Vout and the reference voltage Vref, convert the analog output voltage Vout into a digital output voltage, and output the digital output voltage.

The digital PWM 242 may receive the digital output voltage from the analog-to-digital converter 241. The digital PWM 242 may adjust a pulse width of the digital output voltage, and may transmit a result of the adjustment to the gate controller 243.

The gate controller 243 may generate voltages to be provided to the gates of the switches P1 to Pm and N1 to Nm (see FIG. 2B) of the converting circuit 100A (see FIG. 2A). The first voltage generator 244 may generate voltages provided to the gates of the transistors M1 and M2 (see FIG. 2A) of the converting circuit 100A. The second voltage generator 245 may generate a reference voltage Vref provided to the analog-to-digital converter 241.

In an example embodiment, the control circuit 200B may be implemented through different processes.

For example, in view of performance, power, and area (PPA), it may be more effective to implement the digital PWM 242 through a process having relatively improved FOM characteristics. In an embodiment, as illustrated in FIGS. 12A and 12B, the analog-to-digital converter 241, digital PWM 242, and gate controller 243 of the control circuit 200B may be disposed in the first region 210, and devices disposed in a first region 210 may be implemented on a first die Die1 through a process having relatively improved FOM characteristics. In an embodiment, the devices of the control circuit 200B may be implemented on the first die Die2 together with the devices of the converting circuit 100 disposed in the first region 111 (see FIG. 1A).

In addition, for example, in view of bipolar characteristics of the voltage generator 245 generating the reference voltage Vref or the like, it may be more effective to implement the voltage generator 245 through a process having relatively low FOM characteristics. In an embodiment, as illustrated in FIGS. 12A and 12B, the first and second voltage generators 244 and 245 of the control circuit 200B may be disposed in a second region 220, and devices disposed in the second region 220 may be implemented on a second die Die2 through a process having relatively low FOM characteristics. In an embodiment, the devices of the control circuit 200B may be implemented on the second die Die2 together with the devices of the converting circuit 100 disposed in the second region 112 (see FIG. 1A).

As described above, the control circuit 200B according to an example embodiment may be implemented in a three-dimensional form through different processes.

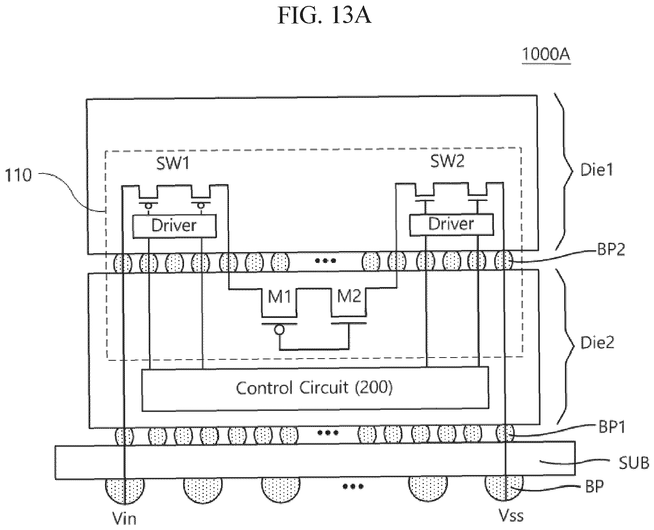

FIGS. 13A to 13D are diagrams illustrating an example of a three-dimensional implementation of a switching voltage regulator according to an example embodiment.

A switching voltage regulator according to an example embodiment may be implemented in a three-dimensional form through a plurality of dies stacked vertically on a substrate. The dies of the switching voltage regulator are fabricated through processes having different FOM characteristics, and may be bonded to each other in a face-to-face (F2F) or face-to-back (F2B) configuration. For example, devices constituting a converting circuit of the switching voltage regulator may be implemented on each of a plurality of dies, and devices formed on different dies may be electrically connected to each other in a vertical direction. Accordingly, not only may switching loss of the switching voltage regulator be reduced, but also a power transfer path may decrease in length, and thus loss caused by parasitic resistance may be significantly reduced.

Referring to FIG. 13A, a switching voltage regulator 1000A may be implemented in the F2F configuration. For example, an active surface of a first die Die1 and an active surface of a second die Die2 may be bonded to each other.

In more detail, the substrate SUB may be electrically connected to an external circuit such as a printed circuit board (PCB) through an internal connection terminal BP, as illustrated in FIG. 13A.

A plurality of dies may be stacked on a substrate SUB in a direction, perpendicular to a plane of the substrate SUB. For example, the first die Die1 may be disposed on the second die Die2. The second die Die2 may be electrically connected to the substrate SUB through one or more first bumps BP1. The first die Die1 may be electrically connected to the second die Die2 through one or more second bumps BP2.

The first die Die1 and the second die Die2 may be formed through processes having different FOM characteristics. For example, the first die Die1 may be formed through a process having relatively improved FOM characteristics, and the second die Die2 may be formed through a process having relatively low FOM characteristics.

Devices included in the switching voltage regulator 1000A may be implemented on the first die Die1 and the second die Die2. For example, first and second switches SW1 and SW2, performing high-speed switching operations, of the power stage circuits 110 may be implemented on the first die Die1, and first and second transistors M1 and M2, blocking an input voltage, of the power stage circuit 110 may be implemented on the second die Die2.

In FIG. 13A, the control circuit 200 is illustrated as being implemented on the second die Die2, but this is only an example, and devices constituting the control circuit 200 may be implemented on each of the first die Die1 and the second die Die1.

An input voltage Vin and the ground voltage Vss may be transmitted to a first switch SW1 through the internal connection terminal BP and the first and second bumps BP1 and BP2.

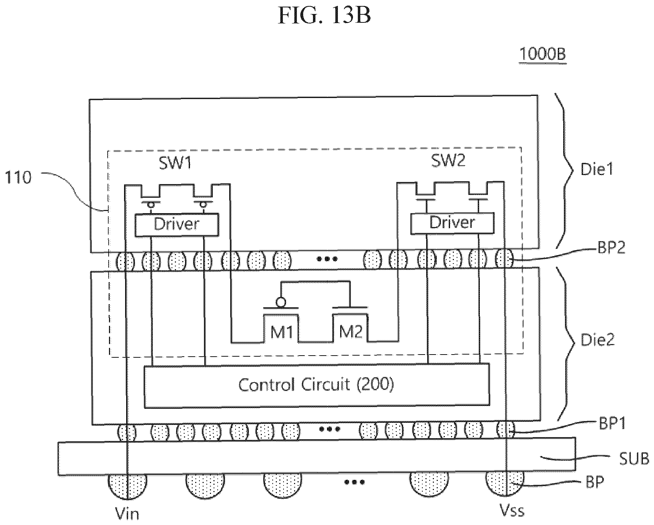

Referring to FIG. 13B, the switching voltage regulator 1000B may be implemented in an F2B configuration. To the extent switching voltage regulator 1000B is similar to switching voltage regulator 1000A, redundant descriptions are omitted for brevity of description. For example, an active surface of the first die Die1 may be bonded to a rear surface of the second die Die2, or a rear surface of the first die Die1 may be bonded to an active surface of the second die Die2.

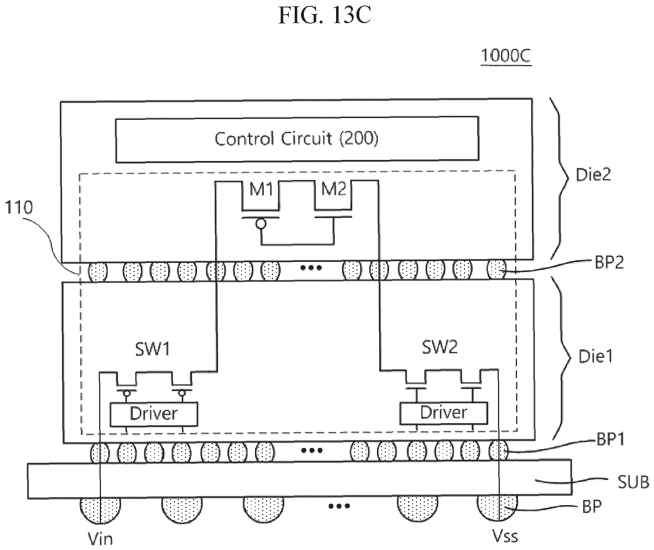

Referring to FIG. 13C, in a switching voltage regulator 1000C, a first die Die1 having improved FOM characteristics may be stacked on a substrate SUB, and a second die Die2 having low FOM characteristics may be stacked on the first die Die1. To the extent switching voltage regulator 1000C is similar to switching voltage regulator 1000A, redundant descriptions are omitted for brevity of description. For example, the switching voltage regulator 1000C may use the first die Die1 having improved FOM characteristics as a bottom plate and the second die Die2 having low FOM characteristics as a top plate.

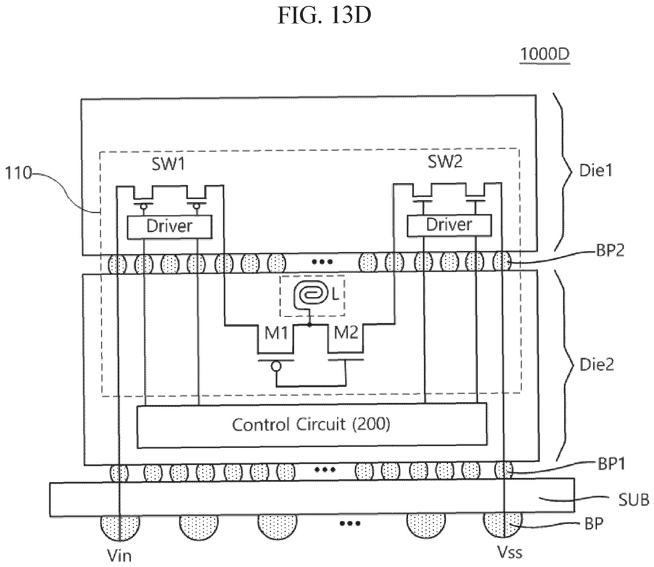

Referring to FIG. 13D, a switching voltage regulator 1000D may be implemented to include an on-chip inductor in which an inductor L is implemented on the first die Die1 or the second die Die2. To the extent switching voltage regulator 1000D is similar to switching voltage regulator 1000A, redundant descriptions are omitted for brevity of description.

For example, the inductor L may be implemented on a second die Die2 having low FOM characteristics together with a first transistor M1 and a second transistor M2, as illustrated in FIG. 13D. However, this is only an example, and the inductor L may be implemented on the first die Die1. In addition, according to an example embodiment, a capacitor may also be implemented as an on-chip capacitor implemented on the first die Die1 or the second die Die2.

As set forth above, a switching voltage regulator according to example embodiments may have reduced switching losses.

While example embodiments have been shown and described above, it will be apparent to those skilled in the art that modifications and variations could be made without departing from the scope of the present invention as defined by the appended claims.

## Claims

1. A switching voltage regulator comprising:
a converting circuit configured to receive an input voltage and to generate an output voltage through a switching operation; and
a control circuit configured to control the switching operation of the converting circuit, the control to cause the output voltage to be generated,
wherein the switching voltage regulator has a first die and a second die and the converting circuit comprises:
at least one switch formed on the first die and configured to perform the switching operation under control of the control circuit; and
at least one blocking transistor formed on the second die and electrically connected to at least one first transistor, and
wherein the first die is vertically stacked on the second die.

2. The switching voltage regulator of claim 1, wherein the at least one switch formed on the first die comprises:
a first switch configured to receive the input voltage; and
a second switch connected to a ground voltage, and
wherein the control circuit is configured to cause the first switch to open and close and to cause the second switch to open and close.

3. The switching voltage regulator of claim 2, wherein:
the first switch comprises a plurality of p-channel metal-oxide semiconductor (PMOS) transistors connected in series, and
the second switch comprises a plurality of n-channel metal-oxide semiconductor (NMOS) transistors connected in series.

4. The switching voltage regulator of claim 2 or 3, wherein the at least one blocking transistor comprises:
a first transistor electrically connected to the first switch; and
a second transistor connected in series to the first transistor and electrically connected to the second switch.

5. The switching voltage regulator of any preceding claim, wherein the converting circuit further comprises at least one switch formed on the second die and configured to perform the switching operation under the control of the control circuit.

6. The switching voltage regulator of claim 5, wherein the at least one blocking transistor comprises:
a p-channel metal-oxide semiconductor (PMOS) transistor electrically connected to the at least one switch formed on the first die; and
an n-channel metal-oxide semiconductor (NMOS) transistor connected in series to the PMOS transistor and electrically connected to the at least one switch formed on the second die.

7. The switching voltage regulator of any preceding claim, wherein the at least one switch formed on the first die comprises:
a first switch configured to receive the input voltage; and
a second switch connected to a ground voltage,
wherein the at least one blocking transistor formed on the second die comprises:
a first transistor having one end electrically connected to the first switch; and
a second transistor having one end connected to the first transistor and another end electrically connected to the second switch, and
wherein the converting circuit further comprises:
a third transistor formed on the first die and having one end connected to the first switch and another end electrically connected to a gate of the first transistor; and
a fourth transistor formed on the first die and having one end connected to the second switch and another end electrically connected to a gate of the second transistor.

8. The switching voltage regulator of claim 7, wherein the converting circuit further comprises a fifth transistor and a sixth transistor, and
wherein the fifth transistor and the sixth transistor are formed on the second die, the fifth transistor and the sixth transistor are connected to one another in series, the fifth transistor is connected in parallel to the first transistor, and the sixth transistor is connected in parallel to the second transistor.

9. The switching voltage regulator of any preceding claim, wherein the converting circuit further comprises at least one switch formed on the second die and connected in series to the at least one blocking transistor.

10. The switching voltage regulator of claim 9, wherein the at least one switch formed on the first die comprises:
a plurality of p-channel metal-oxide semiconductor (PMOS) transistors connected in series and configured to receive the input voltage; and
a plurality of n-channel metal-oxide semiconductor (NMOS) transistors connected in series and configured to connect to a ground voltage, and
wherein the at least one switch formed on the second die comprises:
a first switch connected in parallel to the plurality of PMOS transistors and configured to receive the input voltage; and
a second switch connected in parallel to the plurality of NMOS transistors and connected to the ground voltage.

11. The switching voltage regulator of any preceding claim, further comprising:
an inductor electrically connected between the input voltage and the at least one blocking transistor; and
a capacitor electrically connected between the at least one switch and a ground voltage.

12. The switching voltage regulator of any preceding claim, wherein the control circuit is formed on the second die.

13. The switching voltage regulator of any preceding claim, wherein the control circuit comprises:
a gate controller formed on the first die and configured to generate a first gate voltage controlling the at least one switch; and
a voltage generator formed on the second die and configured to generate a second gate voltage controlling the at least one blocking transistor.

14. A method of manufacturing the switching voltage regulator of any preceding claim including at least claim 3, wherein a number of the plurality of PMOS transistors and a number of the plurality of NMOS transistors are determined based on a voltage provided to a gate of the at least one blocking transistor.

15. The method of claim 14, such that the determined number of the plurality of PMOS transistors and the determined number of the plurality of NMOS transistors decrease as a level of a voltage blocked by the at least one blocking transistor increases.
